Europäisches Patentamt

European Patent Office

Office européen des brevets

(19)

(11) Numéro de publication: **0 023 873**
**B1**

(12) # FASCICULE DE BREVET EUROPEEN

(45) Date de publication du fascicule du brevet:
**21.09.83**

(51) Int. Cl.³: **H 03 G 11/02** // H01P1/15

(21) Numéro de dépôt: **80401142.7**

(22) Date de dépôt: **01.08.80**

(54) **Limiteur passif de puissance à semi-conducteurs réalisé sur des lignes à structure plane, et circuit hyperfréquence utilisant un tel limiteur.**

(30) Priorité: **07.08.79 FR 7920230**

(43) Date de publication de la demande:
**11.02.81 Bulletin 81/6**

(45) Mention de la délivrance du brevet:
**21.09.83 Bulletin 83/38**

(84) Etats contractants désignés:
**AT BE CH DE GB IT LI NL SE**

(56) Documents cités:
**FR-A-1 548 893**
**FR-A-2 260 879**

(73) Titulaire: **THOMSON-CSF, 173, Boulevard Haussmann, F-75379 Paris Cedex 08 (FR)**

(72) Inventeur: **Sillard, Gilles, "THOMSON-CSF"**
**SCPI 173, Boulevard Haussmann, 75360 Paris Cedex 08 (FR)**
Inventeur: **Baril, Michel, "THOMSON-CSF"**
**SCPI 173, Boulevard Haussmann, 75360 Paris Cedex 08 (FR)**

(74) Mandataire: **Benoit, Monique et al, THOMSON-CSF SCPI 173, Bld Haussmann, F-75379 Paris Cedex 08 (FR)**

## Limiteur passif de puissance à semi-conducteurs réalisé sur des lignes à structure plane, et circuit hyperfréquence utilisant un tel limiteur

L'invention concerne un limiteur passif de puissance à semi-conducteurs, réalisé sur des lignes à structure plane. L'utilisation d'un tel limiteur est particulièrement intéressante dans un récepteur hyperfréquence constitué d'amplificateurs à transistors ou de mélangeurs réalisés en technologie microbande. Des limiteurs selon l'invention peuvent également servir à la réalisation de duplexeurs dont le rôle est important dans les équipements de détection électromagnétique ou radar.

Dans les équipements de détection électromagnétique ou radar auxquels la présente invention s'applique plus particulièrement, la protection du récepteur du radar contre les émissions de son propre émetteur ou d'émetteurs voisins a constitué un problème auquel on s'est attaché dès le début.

La protection des récepteurs radar a d'abord été assurée par des tubes à gaz, appelés tubes TR qui, insérés dans la chaîne de réception avaient la structure d'un filtre passe-bande et la propriété d'être passants lorsque l'énergie hyperfréquence appliquée était faible et réfléchissants lorsque cette énergie dépassait quelques watts crête. Ces tubes (qui par ailleurs donnaient satisfaction) présentaient les inconvénients dus à une durée de vie limitée et un léger retard à l'allumage, laissant passer ainsi une partie de la puissance vers le récepteur qui finissait par se détériorer.

L'apparition des diodes P.I.N. a permis dans certains cas de remplacer ces tubes à gaz par des commutateurs plus fiables quant à la durée de vie. Cependant il est nécessaire d'associer à ces diodes PIN un circuit de commande pour les rendre conductrices un peu avant l'émission par une source de polarisation auxiliaire et pour leur appliquer une tension inverse afin de diminuer les pertes au moment de la réception. Ces circuits de commande étant synchrones avec l'émission radar, les commutateurs à diodes PIN ne protègent toutefois pas le récepteur radar contre les émetteurs voisins.

Enfin, l'utilisation de diodes spécialement conçues et associées par paires a permis de réaliser un dispositif de protection à l'état solide, entièrement passif et pouvant supporter des puissances d'une dizaine de kilowatts crête. Ainsi sont déjà réalisés des limiteurs passifs en guide d'ondes utilisant une paire de diodes montées tête-bêche, comme ceux décrits notamment dans la demande publiée sous le numéro 0 020 235, au nom de la demanderesse. Cependant la réalisation de ce type de limiteur sur une ligne à ruban, nécessitant l'emploi de deux diodes montées tête-bêche dans un même boîtier ou sur un même support, est très délicate.

Comme l'utilisation d'un limiteur passif réalisé en structure plane est particulièrement intéressante pour son intégration dans un récepteur constitué d'amplificateurs à transistors ou de mélangeurs réalisés en technologie microbande par exemple, l'invention vise à remédier aux inconvénients de réalisation précités.

Suivant une caractéristique de l'invention, le limiteur passif de puissance à semi-conducteurs comprend au moins deux lignes de transmission à rubans parallèles à configuration de champ électrique dissymétrique, constituées par deux rubans conducteurs placés sur une première face d'une plaquette de substrat diélectrique et d'axes de propagation parallèles $\Delta_1$ et $\Delta_2$ et par un plan de masse placé sur une seconde face opposée à la première, et une ligne de transmission à configuration de champ électrique symétrique, d'axe de propagation $\Delta_3$ perpendiculaire aux axes $\Delta_1$ et $\Delta_2$ des lignes dissymétriques, placée sur la face du substrat sur laquelle est situé le plan de masse, et au moins une paire de diodes, de même polarité et placées dans le même plan sur chacun des deux bords de la ligne symétrique, l'ensemble de ces lignes de transmission et des diodes constituant au moins deux transitions ligne symétrique-ligne dissymétrique.

On réalise ainsi des limiteurs constitués par une ou plusieurs paires de diodes, et des récepteurs hyperfréquence comportant de tels limiteurs.

D'autres caractéristiques et avantages de l'invention apparaîtront dans la description qui suit, illustrée par les figures représentant:
- la fig. 1: une transition entre une ligne microruban et une ligne à fente;
- la fig. 2: un limiteur passif selon l'invention;
- les figs 3 à 5: des exemples de réalisation non limitatifs d'un limiteur passif suivant l'invention;
- la fig. 6: un limiteur passif selon l'invention couplé à un amplificateur;
- la fig. 7: un duplexeur comportant deux limiteurs passifs selon l'invention.

Le limiteur passif suivant l'invention doit supporter une puissance importante, de l'ordre d'une dizaine de kilowatts, et est réalisé dans une structure permettant facilement son intégration dans une structure microbande sur céramique.

Une ligne de transmission microruban comporte une plaquette de substrat diélectrique, en général de l'alumine, sur une face de laquelle est déposé un plan métallique dit plan de masse et sur une autre face opposée à la première est déposé un ruban métallique.

La protection s'effectue selon un mode voisin du mode TEM entre le ruban métallique et le plan de masse; la configuration du champ électrique est dite dissymétrique.

Une ligne de transmission à fente est constituée par une ouverture de largeur constante réalisée dans un plan de masse métallique, déposé sur un substrat diélectrique. La propagation s'effectue selon un mode guidé entre les deux parties du plan de masse, la configuration du champ électrique est dite symétrique.

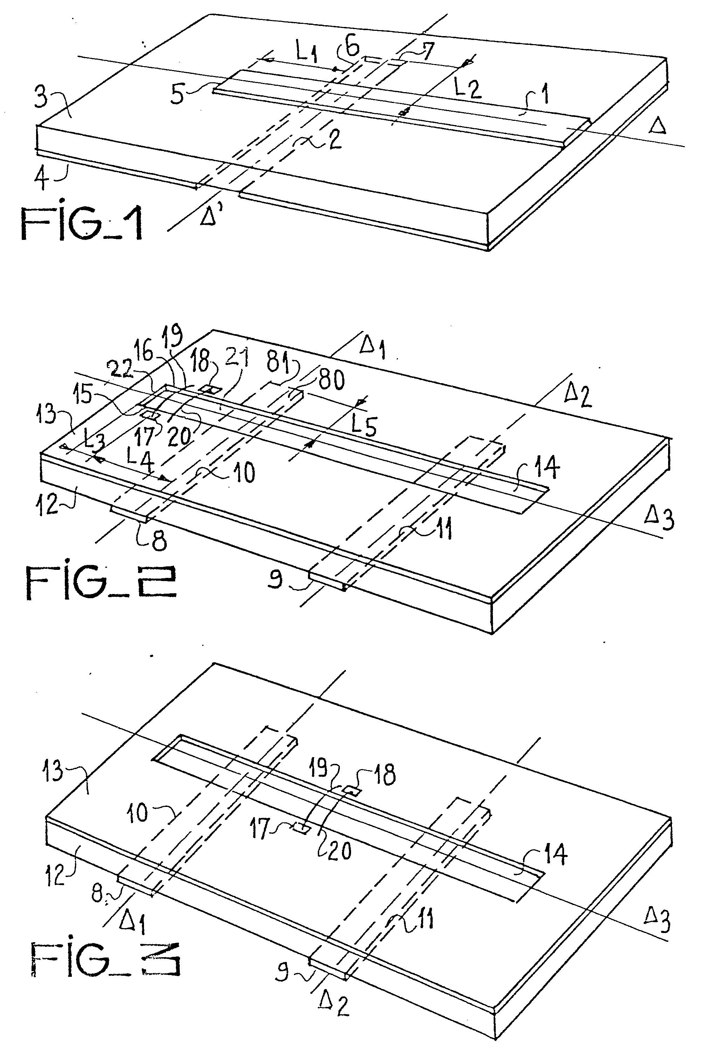

La fig. 1 représente une transition entre une ligne microruban 1 et une ligne à fente 2 réalisées sur une même plaquette 3 de substrat diélectrique.

Leurs axes de propagation respectifs $\Delta$ et $\Delta'$ sont orthogonaux. Lorsque la distance $L_1$ de la ligne microruban, en circuit ouvert, comprise entre l'une de ses extrémités 5 et le bord 6 de la ligne à fente 2 situé du même côté, est égale au quart de la longueur d'onde $\lambda/4$ à la fréquence centrale de la bande de fonctionnement, cela ramène un court-circuit au-dessus du bord 6 correspondant. Une distance $L_2$ en court-circuit entre l'une des extrémités 7 de la ligne à fente 2 et l'axe $\Delta$ de la ligne microruban, égale à $\lambda/4$, permet la propagation dans cette ligne à fente 2.

La fig. 2 représente un limiteur passif selon l'invention. Il comporte deux lignes microrubans 8 et 9, constituées par deux rubans 10 et 11 conducteurs, disposés sur une première face d'une plaquette 12 de substrat diélectrique et par un plan de masse 13 disposé sur une seconde face opposée à la première, et une ligne à fente 14 constituée par une ouverture de largeur constante pratiquée dans le plan de masse 13. Les lignes microrubans 8 et 9 ont des axes de propagation $\Delta_1$ et $\Delta_2$ parallèles entre eux mais orthogonaux à l'axe de propagation $\Delta_3$ de la ligne à fente 14. Une paire de diodes 17 et 18 est placée sur un tronçon 21 de la ligne à fente, compris entre une de ses extrémités 22 et l'axe $\Delta_1$ de la ligne microruban 8 la plus proche. Les diodes 17 et 18 sont placées sur chaque bord 15 et 16 de la ligne à fente 14, symétriquement par rapport à l'axe $\Delta_3$, chacune de ces diodes étant reliée au bord opposé de ladite ligne à fente 14, par un fil de connexion 19 et 20.

Pour réduire au maximum la longueur de ces fils, les diodes 17 et 18 sont placées très près des bords 15 et 16 de la ligne à fente 14. La propagation dans la ligne à fente 14 se faisant selon un mode guidé, le montage ainsi réalisé est tête-bêche.

A bas niveau de puissance, les diodes 17 et 18 se comportent comme des capacités et l'ensemble qu'elles constituent avec le tronçon de ligne à fente 21 est équivalent à un tronçon quart d'onde $\lambda/4$ court-circuité à la fréquence centrale de la bande de fonctionnement. La longueur ou dimension suivant l'axe $\Delta_1$ du tronçon de ligne microruban 80, compris entre l'une des extrémités 81 de la ligne microruban 8 et l'axe $\Delta_3$ est égale à $\lambda/4$, de telle sorte qu'une transition ligne microruban—ligne à fente est réalisée au voisinage de l'intersection des axes $\Delta_1$ et $\Delta_3$.

L'énergie étant appliquée par la ligne à ruban 8 est bien transmise dans la ligne à fente 14, jusqu'à l'autre transition ligne à fente 14—ligne microruban 9, réalisée selon le principe de la fig. 1.

A un niveau de puissance élevée, une des deux diodes 17 ou 18 se comporte comme un court-circuit et désadapte la transition ligne microruban—ligne à fente assurant ainsi une limitation. Grâce au montage tête-bêche des deux diodes 17 et 18 montées dans le même plan, l'une ou l'autre de ces diodes conduit selon la polarité d'un signal hyperfréquence, ce qui protège l'autre diode et assure une bonne tenue en puissance.

Ces deux diodes 17 et 18 peuvent être montées avec ou sans boîtier, le boîtier pouvant protéger la diode contre des chocs éventuels.

La fig. 3 montre une variante de réalisation de l'invention, dans laquelle la paire de diodes 17 et 18 est située entre les deux transitions ligne microruban—ligne à fente, qui forment les deux lignes microrubans 8 et 9 et la ligne à fente 14.

Le limiteur suivant l'invention permet d'obtenir une limitation plus ou moins grande suivant la position des diodes le long de la ligne à fente 14. Lorsque les diodes sont situées entre les deux lignes microrubans 9 et 8, leur couplage est maximal. Dans ce cas la limitation est très bonne et la tenue en puissance est diminuée.

Sur la fig. 4, le limiteur selon l'invention comporte deux paires de diodes (23 et 24) et (25 et 26), placées entre les deux extrémités 27 et 28 de la ligne à fente 14 et les deux lignes microrubans 8 et 9, de telle sorte qu'elles constituent avec les deux tronçons 250 et 260 de la ligne à fente 14, compris respectivement entre les deux extrémités 27 et 28 et les axes $\Delta_1$ et $\Delta_2$, des tronçons quart d'onde court-circuités. Pour réaliser des transitions ligne microruban—ligne à fente, les tronçons de ligne microruban 110 et 111 compris entre les extrémités 112 et 113 respectivement des lignes microrubans 8 et 9 et l'axe $\Delta_3$ doivent être équivalents à des tronçons quart d'onde en circuit ouvert. L'avantage de mettre plusieurs paires de diodes, aux extrémités de la ligne à fente 14 ou entre les deux lignes microrubans 8 et 9 réside dans le fait que les diodes sont moins couplées pour une même limitation, entraînant une meilleure tenue en puissance du limiteur.

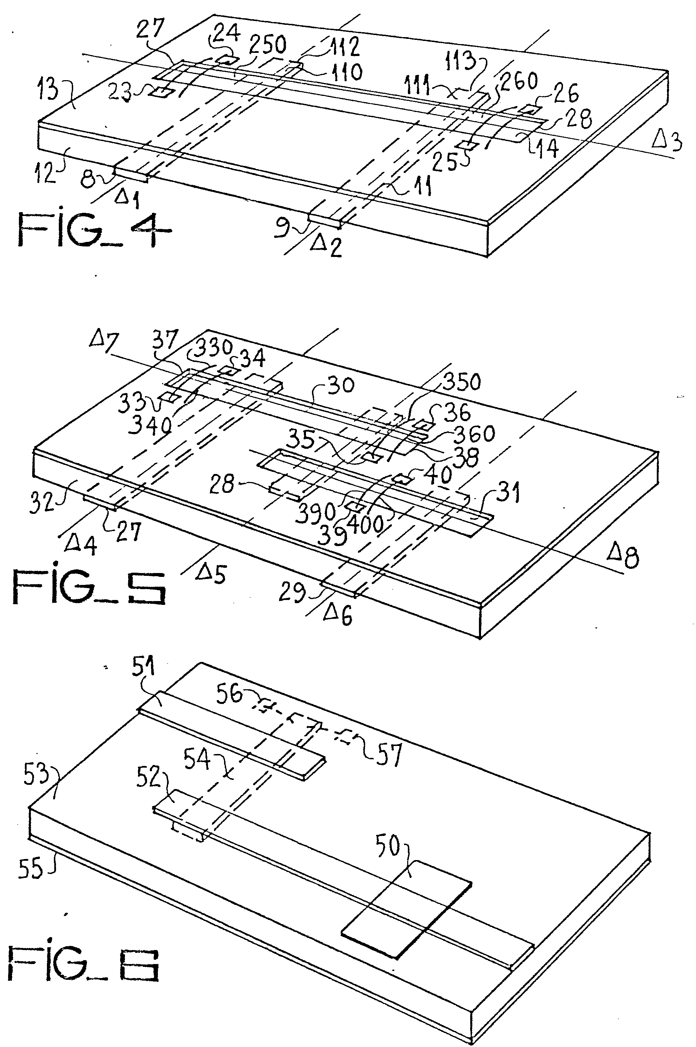

La fig. 5 représente un autre exemple de réalisation de l'invention, non limitatif. Le limiteur est constitué de plusieurs ensembles décrits ci-dessus. Il comporte trois lignes microrubans 27, 28 et 29, d'axes de propagation $\Delta_4$, $\Delta_5$ et $\Delta_6$ parallèles, et deux lignes à fente 30 et 31, d'axes de propagation $\Delta_7$ et $\Delta_8$ parallèles entre eux mais orthogonaux aux axes $\Delta_4$, $\Delta_5$ et $\Delta_6$, ces lignes de propagation étant réalisées sur une plaquette 32 de substrat diélectrique.

Deux paires de diodes (33 et 34) et (35 et 36) sont placées sur chacun des bords de la ligne à fente 30 et reliées à l'autre bord par des fils de connexion (330 et 340) et (350 et 360), entre les extrémités 37 et 38 de la ligne à fente 30 et les deux lignes microrubans 27 et 28, de telle sorte qu'avec les lignes microrubans 27 et 28 elles constituent deux transitions ligne microruban—ligne à fente comme cela a été décrit auparavant. Une autre paire de diodes 39 et 40 est placée sur les bords de la ligne à fente 31, chaque diode étant reliée au bord opposé à celui sur lequel elle est fixée par un fil de connexion 390 et 400 entre les deux axes $\Delta_5$ et $\Delta_6$. Les lignes microrubans 28 et 29 sont telles qu'avec la ligne à fente 31, elles forment deux transitions. Les deux premières paires de diodes assurent une bonne tenue en puissance et une certaine limitation en puissance, qui est accrue par la troisième paire de diodes.

On a ainsi décrit un limiteur à semi-conducteur réalisé sur des lignes à structure plane, mais il peut être réalisé par plusieurs ensembles comme ils ont été décrits précédemment.

Une application particulièrement intéressante de ce limiteur est son intégration dans un récepteur constitué d'amplificateurs à transistors ou de mélangeurs réalisés en technologie microbande comme le montre la fig. 6. La sortie d'un limiteur selon l'invention peut être couplée directement à l'entrée 50 d'un amplificateur réalisé en lignes microbandes.

Le limiteur de la fig. 6 est constitué de deux lignes microrubans 51 et 52, disposées sur une plaquette 53 de substrat diélectrique et d'une ligne à fente 54 réalisée dans le plan de masse 55 des lignes microrubans 51 et 52, ces trois lignes de transmission réalisant des transitions grâce à des diodes 56 et 57 placées comme il a été décrit précédemment pour les figs 2, 3, 4 ou 5. La sortie du limiteur, constituée par la ligne microruban 52, est couplée à l'entrée 50 d'un amplificateur à transistors.

Comme il a été dit dans l'introduction, les limiteurs suivant l'invention qui viennent d'être décrits sont utilisables dans la réalisation de duplexeurs dont le rôle est important dans les équipements de détection électromagnétique ou radar. Le récepteur du radar doit être protégé à la fois contre les émissions d'émetteurs voisins de celui concerné.

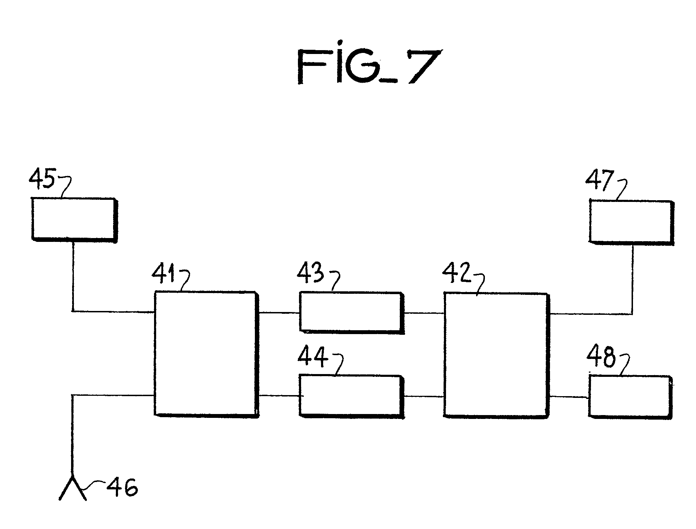

Généralement un duplexeur est constitué de deux limiteurs identiques insérés entre deux coupleurs 3 dB. La fig. 7 représente le schéma d'un duplexeur constitué de deux coupleurs 3 dB 41 et 42 et de deux limiteurs 43 et 44 suivant l'invention.

L'entrée du coupleur 3 dB 41 est reliée d'une part à l'émetteur 45 et d'autre part à l'antenne émettrice-réceptrice 46, alors que ses deux sorties sont reliées respectivement aux deux limiteurs 43 et 44 selon l'invention. La sortie de chaque limiteur est reliée à l'entrée du coupleur 42 dont la sortie est reliée au récepteur 47 et dont l'autre sortie est reliée à une charge dissipatrice 48. A l'émission, l'énergie à grande puissance émise par l'émetteur 45 passe dans le coupleur 41, se réfléchit sur les limiteurs 43 et 44 qui jouent le rôle d'interrupteur, grâce aux diodes qui deviennent équivalentes à des courts-circuits, et est renvoyée à travers le coupleur 41 à l'antenne 46. A la réception, l'énergie passe dans les limiteurs 43 et 44 qui sont passants pour l'énergie transmise à bas niveau. L'énergie est ensuite concentrée par le coupleur 42 avant d'aller au récepteur 47.

Suivant la puissance d'émission et suivant la limitation désirée, les limiteurs 43 et 44 sont réalisés comme les différentes figs 1 à 5 le montrent.

On a ainsi décrit dans ce qui précède des perfectionnements aux limiteurs passifs et aux circuits hyperfréquences comportant de tels limiteurs.

## Revendications

1. Limiteur passif de puissance à semi-conducteurs, caractérisé en ce qu'il comporte au moins deux lignes de transmission, dites microrubans, rubans (8 et 9) à configuration de champ électrique dissymétrique, constituées par deux rubans conducteurs (10 et 11) placés sur une première face d'une plaquette de substrat diélectrique (12) et d'axes de propagation parallèles ($\Delta_1$ et $\Delta_2$) et par un plan de masse (13) placé sur une seconde face opposée à la première, et une ligne de transmission (14), dite ligne à fente, à configuration de champ électrique symétrique, d'axe de propagation ($\Delta_3$) perpendiculaire aux axes ($\Delta_1$ et $\Delta_2$) des lignes dissymétriques, placée sur la face du substrat sur laquelle est situé le plan de masse (13), et au moins une paire de diodes (17 et 18), placées sur chacun des deux bords (15 et 16) de la ligne à fente (14), chacune étant reliée au bord opposé de ladite ligne de manière à former un montage tête-bêche. L'ensemble de ces lignes de transmission et des diodes réalisant au moins deux transitions ligne symétrique–ligne dissymétrique.

2. Limiteur passif selon la revendication 1, caractérisé en ce que les deux diodes (17 et 18) d'une paire sont montées chacune sur un des bords (15 et 16) de la ligne à fente (14), symétriquement par rapport à l'axe ($\Delta_3$) de cette ligne et sont reliées à l'autre bord par un fil (19 ou 20) métallique de connexion.

3. Limiteur passif selon la revendication 1, caractérisé en ce qu'il comporte deux lignes de transmission microrubans (8 et 9), une ligne de transmission à fente (14) et une paire de diodes (17 et 18) placée sur un tronçon (21) de la ligne à fente (14) compris entre une de ses extrémités (22) et l'axe ($\Delta_1$) de la ligne microruban (8) la plus proche, de telle sorte que ces trois lignes de transmission (8, 9 et 14) réalisent deux transitions ligne symétrique–ligne dissymétrique.

4. Limiteur passif selon la revendication 3, caractérisé en ce que le tronçon (21) de ligne à fente (14) comportant les deux diodes (17 et 18) est équivalent à un tronçon court-circuité de longueur égale au quart de la longueur d'onde, $\lambda/4$, à la fréquence centrale de la bande de fonctionnement, et en ce que le tronçon (80) en circuit ouvert de la ligne microruban (8) compris entre une de ses extrémités (81) et l'axe ($\Delta_3$) de la ligne à fente (14) est de longueur égale à $\lambda/4$ à la fréquence centrale de la bande de fonctionnement.

5. Limiteur passif selon la revendication 1, caractérisé en ce qu'il comporte deux lignes de transmission microrubans (8 et 9), une ligne de transmission à fente (14) et une paire de diodes (17 et 18) placée sur les bords de la ligne à fente (14) entre les deux lignes microrubans (8 et 9) où leur couplage est maximum, les trois lignes de transmission réalisant deux transitions ligne dissymétrique–ligne symétrique.

6. Limiteur passif selon la revendication 1, caractérisé en ce qu'il comporte deux paires de diodes (23 et 24) et (25 et 26) placées respectivement sur des tronçons (250 et 260) de ligne à fente, compris entre les deux extrémités (27 et 28) de la ligne à fente (14) et les axes (Δ₁ et Δ₂) des deux lignes microrubans (8 et 9) de telle sorte que ces trois lignes de transmission (8, 9 et 14) réalisent deux transitions ligne symétrique–ligne dissymétrique.

7. Limiteur passif selon la revendication 6, caractérisé en ce que les tronçons (250 et 260) de ligne à fente comportant respectivement les deux paires de diodes (23 et 24) et (25 et 26) sont chacun équivalent à un tronçon court-circuité de longueur égale au quart de la longueur d'onde, λ/4, à la fréquence centrale de la bande de fonctionnement, et en ce que les tronçons de ligne microruban (110 et 111), compris entre les extrémités (112 et 113) respectivement des lignes microrubans (8 et 9) et l'axe (Δ₃) sont de longueurs égales à λ/4 à la fréquence centrale de la bande de fonctionnement.

8. Limiteur passif selon l'une des revendications 1 à 7, caractérisé en ce qu'il comporte plusieurs lignes microrubans, plusieurs lignes à fente et plusieurs paires de diodes, les axes de propagation des lignes microrubans étant parallèles entre eux et orthogonaux aux axes de propagation des lignes à fente qui sont aussi parallèles entre eux, et ces lignes de transmission réalisant plusieurs transitions ligne symétrique–ligne dissymétrique.

9. Récepteur hyperfréquence caractérisé en ce qu'il comporte un limiteur passif selon l'une quelconque des revendications 1 à 8.

10. Duplexeur hyperfréquence caractérisé en ce qu'il comporte un limiteur passif selon l'une quelconque des revendications 1 à 8.

**Claims**

1. Passive semiconductor power limiter, comprising at least two transmission lines, termed micro-strips, comprising strips (8 and 9) having a dissymmetrical electric field configuration, formed of two conductor strips (10 and 11) placed on a first face of a dielectric substrate wafer (12) and having parallel propagation axes (Δ₁ and Δ₂), and of a ground plane (13) placed on a second face opposed to the first face, and a transmission line (14), termed slotted line, having a symmetrical electrical field configuration and a propagation axis (Δ₃) perpendicular to the axes (Δ₁ and Δ₂) of the dissymmetrical lines, and placed on the face of the substrate on which the ground plane (13) is located, and at least a pair of diodes (17 and 18) each placed on one of the two edges (15 and 16) of the slotted line (14) and each being connected to the opposite edge of said line in a manner to form a mutually inverted arrangement, these transmission lines and diodes together forming at least two transitions between symmetrical line and dissymmetrical line.

2. Passive limiter in accordance with claim 1, characterized in that the two diodes (17 and 18) of one pair are each mounted on one of the edges (15 and 16) of the slotted line (14), symmetrically with respect to an axis (Δ₃) of this line, and are connected to the other edge by a metallic connection wire (19 or 20).

3. Passive limiter in accordance with claim 1, characterized in that it comprises two micro-strip transmission lines (8 and 9), a slotted transmission line (14) and a pair of diodes (17 and 18) placed on a section (21) of the slotted line (14) comprised between one of its ends (22) and the axis (Δ₁) of the closest micro-strip line (8), in such a manner that these three transmission lines (8, 9 and 14) form two transitions between symmetrical line and dissymmetrical line.

4. Passive limiter in accordance with claim 3, characterized in that the section (21) of the slotted line (14) comprising the two diodes (17 and 18) is equivalent to a short-circuited section of a length equal to a quarter of the wave length λ/4, at the center frequency of the operation band, and in that the open circuit section (80) of the micro-strip line (8) comprised between one of its ends (81) and the axis (Δ₃) of the slotted line (14) has a length equal to λ/4 at the center frequency of the operating band.

5. Passive limiter in accordance with claim 1, characterized in that it comprises two micro-strip transmission lines (8 and 9), one slotted transmission line (14) and a pair of diodes (17 and 18) placed on the edges of the slotted line (14) between the two micro-strip lines (8 and 9) at the location of maximum coupling, the three transmission lines forming two transitions between dissymmetrical line and symmetrical line.

6. Passiver limiter in accordance with claim 1, characterized in that it comprises two diode pairs (23 and 24) and (25 and 26) respectively placed on the sections (250 and 260) of the slotted line comprised between the two ends (27 and 28) of the slotted line (14) and the axes (Δ₁ and Δ₂) of the two micro-strip lines (8 and 9) in such a manner that these three transmission lines (8, 9 and 14) form two transitions between symmetrical line and dissymmetrical line.

7. Passive limiter in accordance with claim 6, characterized in that the sections (250 and 260) of the slotted line respectively comprising the two diode pairs (23 and 24), and (25 and 26) are each equivalent to a short-circuited section of a length equal to a quarter of the wave length, λ/4 at the center frequency of the operating band, and in that the micro-strip line sections (110 and 111) comprised between the ends (112 and 113), respectively, of the micro-strip lines (8 and 9) and the axis (Δ₃) have lengths equal to λ/4 at the center frequency of the operating band.

8. Passive limiter in accordance with any of claims 1 to 7, characterized in that it comprises a plurality of micro-strip lines, a plurality of slotted lines and a plurality of diode pairs, the propagation axes of these micro-strip lines being parallel with each other and perpendicular to the propagation axes of the slotted lines which are also parallel to each other, these transmission lines forming a plurality of transitions between symmetrical line and dissymmetrical line.

9. Microwave receiver, characterized in that it comprises a passive limiter in accordance with any of claims 1 to 8.

10. Microwave duplexer, characterized in that it comprises a passive limiter in accordance with any of claims 1 to 8.

**Patentansprüche**

1. Passiver Halbleiter-Leistungsbegrenzer, dadurch gekennzeichnet, dass er wenigstens zwei Übertragungsleitungen, die als Mikrobandleitungen bezeichnet werden, umfasst, die Streifen (8 und 9) mit unsymmetrischer Konfiguration des elektrischen Feldes bilden und gebildet sind durch zwei Leiterstreifen (10 und 11), die auf einer ersten Fläche einer dielektrischen Halbleiterscheibe (12) angeordnet sind und parallele Ausbreitungsachsen ($\Delta_1$ und $\Delta_2$) aufweisen, und durch eine Masseebene (13), die auf einer zweiten, der ersten gegenüberliegenden Fläche angeordnet ist, und eine Übertragungsleitung (14) umfasst, die als Schlitzleitung bezeichnet wird und eine symmetrische Konfiguration des elektrischen Feldes aufweist, mit einer Ausbreitungsachse ($\Delta_3$), die senkrecht zu den Achsen ($\Delta_1$ und $\Delta_2$) der symmetrischen Leitungen ist, und welche auf derjenigen Fläche des Substrates angeordnet ist, auf welcher die Masseebene (13) liegt, sowie wenigstens ein Diodenpaar aus Dioden (17 und 18) umfasst, die jeweils auf einem der beiden Ränder (15 und 16) der Schlitzleitung (14) angeordnet und mit dem gegenüberliegenden Rand derselben Leitung so verbunden sind, dass sie einander entgegengesetzt angeordnet sind, wobei die aus diesen Übertragungsleitungen und den Dioden gebildete Einheit wenigstens zwei Übergänge zwischen symmetrischer Leitung und unsymmetrischer Leitung bilden.

2. Passiver Begrenzer nach Anspruch 1, dadurch gekennzeichnet, dass die beiden Dioden (17 und 18) eines Paares jeweils auf einem der Ränder (15 und 16) der Schlitzleitung (14) symmetrisch in bezug auf eine Achse ($\Delta_3$) dieser Leitung angeordnet und mit dem anderen Rand durch einen metallischen Verbindungsdraht (19 oder 20) verbunden sind.

3. Passiver Begrenzer nach Anspruch 1, dadurch gekennzeichnet, dass er zwei Mikroband-Übertragungsleitungen (8 und 9), eine Schlitz-Übertragungsleitung (14) und ein Diodenpaar (17 und 18) umfasst, das auf einem Abschnitt (21) der Schlitzleitung (14) angeordnet ist, welcher zwischen einem ihrer Enden (22) und der Achse ($\Delta_1$) der am nächsten liegenden Mikrobandleitung (8) enthalten ist, so dass diese drei Übertragungsleitungen (8, 9 und 14) zwei Übergänge zwischen symmetrischer Leitung und unsymmetrischer Leitung bilden.

4. Passiver Begrenzer nach Anspruch 3, dadurch gekennzeichnet, dass der die beiden Dioden (17 und 18) aufweisende Abschnitt (21) der Schlitzleitung (14) äquivalent einem kurzgeschlossenen Abschnitt einer Länge ist, die gleich einem Viertel der Wellenlänge, d.h. $\lambda/4$, bei der Mittenfrequenz des Betriebsbandes ist, und dass der einen offenen Stromkreis bildenden Abschnitt (80) der Mikrobandleitung, welcher zwischen einem seiner Enden (81) und der Achse ($\Delta_3$) der Schlitzleitung (14) enthalten ist, eine Länge aufweist, die bei der Mittenfrequenz des Betriebsbandes gleich $\lambda/4$ ist.

5. Passiver Begrenzer nach Anspruch 1, dadurch gekennzeichnet, dass er zwei Mikroband-Übertragungsleitungen (8 und 9), eine Schlitz-Übertragungsleitung (14) und ein Diodenpaar (17 und 18) umfasst, das auf den Rändern der Schlitzleitung (14) zwischen den beiden Mikrobandleitungen (8 und 9) angeordnet ist, wo ihre Kopplung maximal ist, wobei die drei Übertragungsleitungen zwei Übergänge zwischen unsymmetrischer Leitung und symmetrischer Leitung bilden.

6. Passiver Begrenzer nach Anspruch 1, dadurch gekennzeichnet, dass er zwei Diodenpaare (23 und 24) sowie (25 und 26) umfasst, die jeweils auf Abschnitten (250 und 260) der Schlitzleitung angeordnet sind, die zwischen den beiden Enden (27 und 28) der Schlitzleitung (14) und den Achsen ($\Delta_1$ und $\Delta_2$) der beiden Mikrobandleitungen (8 und 9) enthalten sind, so dass diese drei Übertragungsleitungen (8, 9 und 14) zwei Übergänge zwischen symmetrischer Leitung und unsymmetrischer Leitung bilden.

7. Passiver Begrenzer nach Anspruch 6, dadurch gekennzeichnet, dass die Schlitzleitungsabschnitte (250 und 260), welche jeweils eines der beiden Diodenpaare (23 und 24) bzw. (25 und 26) umfassen, jeweils äquivalent einem kurzgeschlossenen Abschnitt einer Länge sind, die gleich einem Viertel der Wellenlänge bzw. $\lambda/4$ bei der Mittenfrequenz des Betriebsbandes ist, und dass die Bandleitungsabschnitte (110 und 111), die zwischen den Enden (112 und 113) der Mikrobandleitungen (8 und 9) und der Achse ($\Delta_3$) liegen, Längen von $\lambda/4$ bei der Mittenfrequenz des Betriebsbandes aufweisen.

8. Passiver Begrenzer nach einem der Ansprüche 1 bis 7, dadurch gekennzeichnet, dass er mehrere Mikrobandleitungen, mehrere Schlitzleitungen und mehrere Diodenpaare umfasst, wobei die Ausbreitungsachsen der Mikrobandleitungen zueinander parallel und senkrecht zu den Ausbreitungsachsen der Schlitzleitungen sind, die zueinander ebenfalls parallel sind, und wobei diese Übertragungsleitungen mehrere Übergänge zwischen symmetrischer Leitung und unsymmetrischer Leitung bilden.

9. Mikrowellenempfänger, dadurch gekennzeichnet, dass er einen passiven Begrenzer nach einem der Ansprüche 1 bis 8 umfasst.

10. Mikrowellen-Duplexer, dadurch gekennzeichnet, dass er einen passiven Begrenzer nach einem der Ansprüche 1 bis 8 umfasst.

FIG_1

FIG_2

FIG_3

FIG_4

FIG_5

FIG_6

# FIG_7